# EUROPEAN PATENT SPECIFICATION

(11) **EP 4 189 733 B1**
(45) Date of publication and mention of the grant of the patent: **18.11.2026**
(21) Application number: 21853661.3
(22) Date of filing: 16.07.2021
(51) Int. Cl.: H05B 3/00, H10P 72/00, H10P 72/76

(54) **WAFER EDGE TEMPERATURE CORRECTION IN BATCH THERMAL PROCESS CHAMBER**
WAFERKANTENTEMPERATURKORREKTUR IN EINER STAPELWÄRMEPROZESSKAMMER
CORRECTION DE TEMPÉRATURE DE BORD DE TRANCHE DANS UNE CHAMBRE DE TRAITEMENT THERMIQUE PAR LOTS

(30) Priority: 03.08.2020 IN 202041033207
(43) Date of publication of application: 07.06.2023
(73) Proprietor: Applied Materials, Inc., Santa Clara, California 95054 (US)
(72) Inventor: SHAH, Kartik Bhupendra, Santa Clara, California 95054 (US); CHU, Schubert S., San Francisco, California 94127 (US); TANNOUS, Adel George, Santa Clara, California 95050 (US); MORADIAN, Ala, Santa Clara, California 95054 (US); MYO, Nyi O., San Jose, California 95120 (US); KUMAR, Surajit, Santa Clara, California 95054 (US); ZHU, Zuoming, Santa Clara, California 95054 (US); BURROWS, Brian Hayes, Santa Clara, California 95054 (US); PANDEY, Vishwas Kumar, Bangalore KA 560 066 (IN); LAU, Shu-Kwan, Santa Clara, California 95054 (US); RANGAPPA, Srinivasa, Bangalore KA 560 066 (IN)
(74) Representative: Zimmermann & Partner Patentanwälte mbB
(86) International application number: PCT/US2021/042065
(87) International publication number: WO 2022/031422

(56) References cited:
- JP-A- 2007 251 126
- JP-A- 2020 027 941
- US-A1- 2002 005 400
- US-A1- 2003 049 372
- US-A1- 2007 084 406

## Description

### BACKGROUND

### Field

Examples described herein generally relate to the field of semiconductor processing, and more specifically, to pre-epitaxial baking of wafers.

### Description of the Related Art

In conventional semiconductor fabrication, wafers are pre-cleaned to remove contaminants, such as oxides, prior to thin film growth thereon by epitaxial processes. Pre-cleaning of wafers is performed by baking the wafers in a hydrogen atmosphere either in a single wafer epitaxial (Epi) chamber or in a furnace. Single wafer Epi chambers have been designed to provide uniform temperature distribution over a wafer disposed within a processing volume and precise control of gas flow over the wafer. However, a single wafer Epi chamber processes one wafer at a time, and thus may not provide required throughputs in fabrication processes. Furnaces enable batch processing of multiple wafers. However, furnaces do not provide uniform temperature distribution over each wafer and/or between wafers disposed in a processing volume, and thus may not provide required qualities in fabricated devices. In particular, heat loss in the vicinity of wafer edges causes highly non-uniform temperature distribution over each wafer.

Therefore, there is need for a process and processing equipment that is able to perform batch multi-wafer process while reducing heat loss in the vicinity of wafer edges to provide uniform temperature distribution over a wafer.

With respect to the state of the art, reference is made to patent documents US 2002/005400 A1 and US 2003/0049372 A1.

Document US 2002/005400 A1 describes a system for heating a plurality of semiconductor wafers at the same time. The apparatus includes a thermal processing chamber containing a substrate holder designed to hold from about three to about ten wafers. The thermal processing chamber is surrounded by light energy sources which heat the wafers contained in the chamber. The light energy sources can heat the wafers directly or indirectly. In one embodiment, the thermal processing chamber includes a liner made from a heat conductive material. The light energy sources are used to heat the liner which, in turn, heats the wafers. In an alternative embodiment, energy dispersing plates are placed in between adjacent wafers. Light energy being emitted by the light energy sources enters the energy dispersing members and gets distributed across the surface of adjacent wafers for heating the wafers uniformly.

Document US 2003/0049372 A1 describes a chemical vapor deposition reactor including a wafer boat with a vertical stack of horizontally oriented susceptors serving as thermal plates and each having pins extending upward for suspending a wafer between a pair of susceptors. Reactant gas injector and exhaust apparatus are positioned to concentrate a forceful supply of reactant gas across each wafer at a speed in excess of 10 cm/sec. The pressure is held in the range of 0.1 to 5,000 mTorr. The forceful gas flow avoids gas depletion effects, thinning the boundary layer and resulting in faster delivery of reactants to substrate surfaces, resulting in surface rate reaction limited operation. A plurality of individually controllable heaters are spaced vertically around the sides of the boat. Temperature sensors monitor the temperature along the boat height and provide input to a controller for adjusting the heater drive to optimize the temperature uniformity.

### SUMMARY

According to the invention, a process kit according to claim 1, a processing chamber according to claim 8, and a processing system according to claims 11 are provided.

According to an embodiment, the process kit includes an outer liner, an inner liner having a plurality of first inlet holes disposed on an injection side of the inner liner and configured to be in fluid communication with a gas injection assembly of a processing chamber, and a plurality of first outlet holes disposed on an exhaust side of the inner liner and configured to be in fluid communication with a gas exhaust assembly of the processing chamber, a first ring reflector disposed between the outer liner and the inner liner, a top plate and a bottom plate attached to an inner surface of the inner liner, the top plate and the bottom plate forming an enclosure together with the inner liner, a cassette disposed within the enclosure, the cassette comprising a plurality of shelves configured to retain a plurality of substrates thereon, and an edge temperature correcting element disposed between the inner liner and the first ring reflector.

According to an embodiment, the processing chamber includes a housing structure having a first side wall and a second side wall opposite the first side wall in a first direction, a gas injection assembly coupled to the first side wall, a gas exhaust assembly coupled to the second side wall, a quartz chamber disposed within the housing structure, a process kit disposed within the quartz chamber, the process kit comprising a cassette having a plurality of shelves configured to retain a plurality of substrates thereon, a plurality of upper lamp modules disposed on a first side of the quartz chamber and configured to provide radiative heat to the plurality of substrates, a plurality of lower lamp modules disposed on a second side of the quartz chamber opposite the first side in a second direction perpendicular to the first direction and configured to provide radiative heat to the plurality of substrates, and a lift-rotation mechanism configured to move the cassette in the second direction and rotate the cassette about the second direction. The process kit further includes an outer liner, an inner liner having a plurality of first inlet holes disposed on an injection side of the inner liner and configured to be in fluid communication with the gas injection assembly, and a plurality of first outlet holes disposed on an exhaust side of the inner liner and configured to be in fluid communication with the gas exhaust assembly, a first ring reflector disposed between the outer liner and the inner liner, a top plate and a bottom plate attached to an inner surface of the inner liner, the top plate and the bottom plate forming an enclosure together with the inner liner, the cassette being disposed within the enclosure, and an edge temperature correcting element disposed between the inner liner and the first ring reflector.

According to an embodiment, the processing system includes a processing chamber including a housing structure having a first side wall and a second side wall opposite the first side wall in a first direction, a gas injection assembly coupled to the first side wall, a gas exhaust assembly coupled to the second side wall, a quartz chamber disposed within the housing structure, a process kit disposed within the quartz chamber, the process kit including a cassette having a plurality of shelves configured to retain a plurality of substrates thereon, an outer liner, an inner liner having a plurality of first inlet holes disposed on an injection side of the inner liner and configured to be in fluid communication with the gas injection assembly, and a plurality of first outlet holes disposed on an exhaust side of the inner liner and configured to be in fluid communication with the gas exhaust assembly, and a first ring reflector disposed between the outer liner and the inner liner, a top plate and a bottom plate attached to an inner surface of the inner liner, the top plate and the bottom plate forming an enclosure together with the inner liner, the cassette being disposed within the enclosure, and an edge temperature correcting element disposed between the inner liner and the first ring reflector, a plurality of upper lamp modules disposed on a first side of the quartz chamber and configured to provide radiative heat to the plurality of substrates, a plurality of lower lamp modules disposed on a second side of the quartz chamber opposite the first side in a second direction perpendicular to the first direction and configured to provide radiative heat to the plurality of substrates, a lift-rotation mechanism configured to move the cassette in the second direction and rotate the cassette about the second direction, and a transfer robot configured to transfer the plurality of substrates into and from the process kit disposed in the processing chamber.

### BRIEF DESCRIPTION OF THE DRAWINGS

So that the manner in which the above recited features of the present disclosure can be understood in detail, a more particular description, briefly summarized above, may be had by reference to examples, some of which are illustrated in the appended drawings. It is to be noted, however, that the appended drawings illustrate only some examples and are therefore not to be considered limiting of the scope of this disclosure, for the disclosure may admit to other equally effective examples.
Figure 1 is a schematic top-view diagram of an example of a batch multichamber processing system according to one or more embodiments.
Figure 2 is a schematic cross-sectional view of an exemplary processing chamber that may be used to perform batch multi-wafer cleaning processes according to one or more embodiments.
Figure 3 is a schematic cross-sectional view of a process kit according to one embodiment.
Figure 4 is a schematic cross-sectional view of a process kit according to one embodiment.
Figure 5 is a schematic cross-sectional view of a process kit according to one embodiment.

To facilitate understanding, identical reference numerals have been used, wherever possible, to designate identical elements that are common to the figures.

### DETAILED DESCRIPTION

Generally, examples described herein generally relate to the field of semiconductor processing, and more specifically, to pre-epitaxial baking of wafers.

Some examples described herein provide a multi-wafer batch processing system where multiple substrates are pre-cleaned to remove contaminants, such as oxides, prior to thin film growth thereon by epitaxial processes by baking the substrates in a hydrogen atmosphere in an epitaxial (Epi) chamber while uniform temperature distribution is maintained over a substrate and between substrates disposed within a processing volume. Thus, the multi-wafer batch processing system may provide improved qualities and throughputs in fabricated devices.

Various different examples are described below. Although multiple features of different examples may be described together in a process flow or system, the multiple features can each be implemented separately or individually and/or in a different process flow or different system.

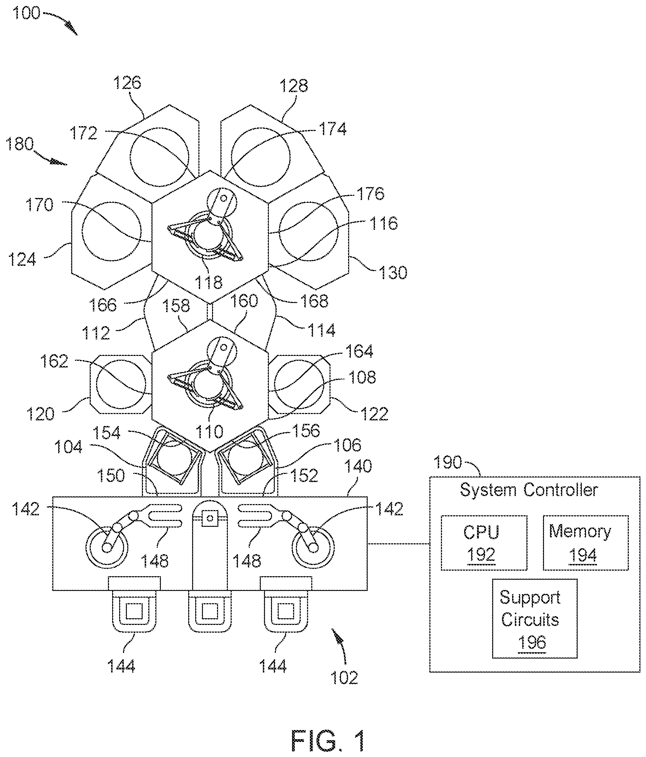

Figure 1 is a schematic top-view diagram of an example of a processing system 100 according to one or more embodiments. The processing system 100 generally includes a factory interface 102, load lock chambers 104, 106, transfer chambers 108, 116 with respective transfer robots 110, 118, holding chambers 112, 114, and processing chambers 120, 122, 124, 126, 128, 130. As detailed herein, substrates in the processing system 100 can be processed in and transferred between the various chambers without being exposed to an ambient environment exterior to the processing system 100. For example, substrates can be processed in and transferred between the various chambers in a low pressure (e.g., less than or equal to about 300 Torr) or vacuum environment without breaking the low pressure or vacuum environment between various processes performed on the substrates in the processing system 100. Accordingly, the processing system 100 may provide for an integrated solution for some processing of substrates.

Examples of a processing system that may be suitably modified in accordance with the teachings provided herein include the Endura^{®}, Producer^{®} or Centura^{®} integrated processing systems or other suitable processing systems commercially available from Applied Materials, Inc., located in Santa Clara, California. It is contemplated that other processing systems (including those from other manufacturers) may be adapted to benefit from aspects described herein.

In the illustrated example of Figure 1, the factory interface 102 includes a docking station 140 and factory interface robots 142 to facilitate transfer of substrates. The docking station 140 is configured to accept one or more front opening unified pods (FOUPs) 144. In some examples, each factory interface robot 142 generally comprises a blade 148 disposed on one end of the respective factory interface robot 142 configured to transfer substrates from the factory interface 102 to the load lock chambers 104, 106.

The load lock chambers 104, 106 have respective ports 150, 152 coupled to the factory interface 102 and respective ports 154, 156 coupled to the transfer chamber 108. The transfer chamber 108 further has respective ports 158, 160 coupled to the holding chambers 112, 114 and respective ports 162, 164 coupled to processing chambers 120, 122. Similarly, the transfer chamber 116 has respective ports 166, 168 coupled to the holding chambers 112, 114 and respective ports 170, 172, 174, 176 coupled to processing chambers 124, 126, 128, 130. The ports 154, 156, 158, 160, 162, 164, 166, 168, 170, 172, 174, 176 can be, for example, slit openings with slit valves for passing substrates therethrough by the transfer robots 110, 118 and for providing a seal between respective chambers to prevent a gas from passing between the respective chambers. Generally, any port is open for transferring a substrate therethrough; otherwise, the port is closed.

The load lock chambers 104, 106, transfer chambers 108, 116, holding chambers 112, 114, and processing chambers 120, 122, 124, 126, 128, 130 may be fluidly coupled to a gas and pressure control system (not shown). The gas and pressure control system can include one or more gas pumps (e.g., turbo pumps, cryo-pumps, roughing pumps, etc.), gas sources, various valves, and conduits fluidly coupled to the various chambers. In operation, a factory interface robot 142 transfers a substrate from a FOUP 144 through a port 150 or 152 to a load lock chamber 104 or 106. The gas and pressure control system then pumps down the load lock chamber 104 or 106. The gas and pressure control system further maintains the transfer chambers 108, 116 and holding chambers 112, 114 with an interior low pressure or vacuum environment (which may include an inert gas). Hence, the pumping down of the load lock chamber 104 or 106 facilitates passing the substrate between e.g., the atmospheric environment of the factory interface 102 and the low pressure or vacuum environment of the transfer chamber 108.

With the substrate in the load lock chamber 104 or 106 that has been pumped down, the transfer robot 110 transfers the substrate from the load lock chamber 104 or 106 into the transfer chamber 108 through the port 154 or 156. The transfer robot 110 is then capable of transferring the substrate to and/or between any of the processing chambers 120, 122 through the respective ports 162, 164 for processing and the holding chambers 112, 114 through the respective ports 158, 160 for holding to await further transfer. Similarly, the transfer robot 118 is capable of accessing the substrate in the holding chamber 112 or 114 through the port 166 or 168 and is capable of transferring the substrate to and/or between any of the processing chambers 124, 126, 128, 130 through the respective ports 170, 172, 174, 176 for processing and the holding chambers 112, 114 through the respective ports 166, 168 for holding to await further transfer. The transfer and holding of the substrate within and among the various chambers can be in the low pressure or vacuum environment provided by the gas and pressure control system.

The processing chambers 120, 122, 124, 126, 128, 130 can be any appropriate chamber for processing a substrate. In some examples, the processing chamber 122 can be capable of performing a cleaning process; the processing chamber 120 can be capable of performing an etch process; and the processing chambers 124, 126, 128, 130 can be capable of performing respective epitaxial growth processes. The processing chamber 122 may be a SiCoNi^{™} Preclean chamber available from Applied Materials of Santa Clara, Calif. The processing chamber 120 may be a Selectra^{™} Etch chamber available from Applied Materials of Santa Clara, Calif.

A system controller 190 is coupled to the processing system 100 for controlling the processing system 100 or components thereof. For example, the system controller 190 may control the operation of the processing system 100 using a direct control of the chambers 104, 106, 108, 112, 114, 116, 120, 122, 124, 126, 128, 130 of the processing system 100 or by controlling controllers associated with the chambers 104, 106, 108, 112, 114, 116, 120, 122, 124, 126, 128, 130. In operation, the system controller 190 enables data collection and feedback from the respective chambers to coordinate performance of the processing system 100.

The system controller 190 generally includes a central processing unit (CPU) 192, memory 194, and support circuits 196. The CPU 192 may be one of any form of a general purpose processor that can be used in an industrial setting. The memory 194, or non-transitory computer-readable medium, is accessible by the CPU 192 and may be one or more of memory such as random access memory (RAM), read only memory (ROM), floppy disk, hard disk, or any other form of digital storage, local or remote. The support circuits 196 are coupled to the CPU 192 and may comprise cache, clock circuits, input/output subsystems, power supplies, and the like. The various methods disclosed herein may generally be implemented under the control of the CPU 192 by the CPU 192 executing computer instruction code stored in the memory 194 (or in memory of a particular processing chamber) as, e.g., a software routine. When the computer instruction code is executed by the CPU 192, the CPU 192 controls the chambers to perform processes in accordance with the various methods.

Other processing systems can be in other configurations. For example, more or fewer processing chambers may be coupled to a transfer apparatus. In the illustrated example, the transfer apparatus includes the transfer chambers 108, 116 and the holding chambers 112, 114. In other examples, more or fewer transfer chambers (e.g., one transfer chamber) and/or more or fewer holding chambers (e.g., no holding chambers) may be implemented as a transfer apparatus in a processing system.

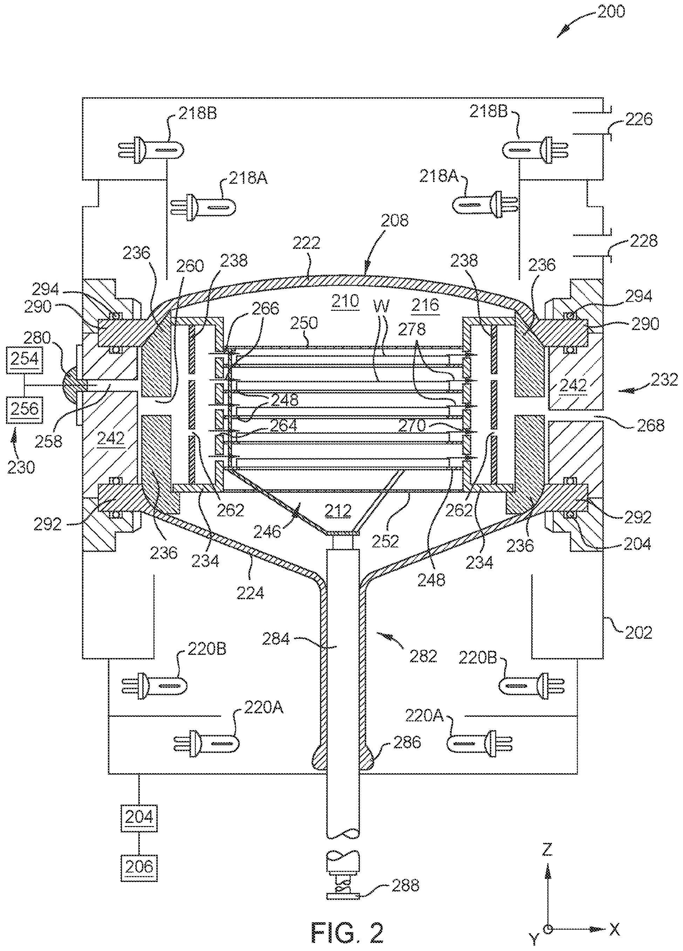

Figure 2 is a schematic cross-sectional view of an exemplary processing chamber 200 that may be used to perform batch multi-wafer cleaning processes, such as a baking process in hydrogen atmosphere at a temperature of about 800°C. The processing chamber 200 may be any one of processing chambers 120, 122, 124, 126, 128, 130 from Figure 1. Non-limiting examples of the suitable processing chambers that may be modified according to embodiments disclosed herein may include the RP EPI reactor, Elvis chamber, and Lennon chamber, which are all commercially available from Applied Materials, Inc. of Santa Clara, Calif. The processing chambers 200 may be added to a CENTURA^{®} integrated processing system available from Applied Materials, Inc., of Santa Clara, Calif. While the processing chamber 200 is described below to be utilized to practice various embodiments described herein, other semiconductor processing chambers from different manufacturers may also be used to practice the embodiment described in this disclosure.

The processing chamber 200 includes a housing structure 202, a support system 204, and a controller 206. The housing structure 202 is made of a process resistant material, such as aluminum or stainless steel. The housing structure 202 encloses various function elements of the processing chamber 200, such as a quartz chamber 208, which includes an upper portion 210 and a lower portion 212. A process kit 214 is adapted to receive multiple substrates W within the quartz chamber 208, in which a processing volume 216 is contained.

As used herein, the term "substrate" refers to a layer of material that serves as a basis for subsequent processing operations and includes a surface to be disposed for forming thin films thereon. The substrate may be a silicon wafer, silicon oxide, strained silicon, silicon germanium, doped or undoped polysilicon, doped or undoped silicon wafers, patterned or non-patterned wafers silicon on insulator (SOI), carbon doped silicon oxides, silicon nitride, indium phosphide, germanium, gallium arsenide, gallium nitride, quartz, fused silica, glass, or sapphire. Moreover, the substrate is not limited to any particular size or shape. The substrate can be a round wafer having a 200 mm diameter, a 300 mm diameter or other diameters, such as 450 mm, among others. The substrate W can also be any polygonal, square, rectangular, curved or otherwise non-circular workpiece, such as a polygonal glass substrate.

Heating of the substrates W may be provided by radiation sources, such as one or more upper lamp modules 218A, 218B above the quartz chamber 208 in the Z-direction and one or more lower lamp modules 220A, 220B below the quartz chamber 208 in the Z-direction. In one embodiment, the upper lamp modules 218A, 218B and the lower lamp modules 220A, 220B are infrared lamps. Radiation from the upper lamp modules 218A, 218B and the lower lamp modules 220A, 220B travels through an upper quartz window 222 in the upper portion 210, and through a lower quartz window 224 in the lower portion 212. In some embodiments, cooling gases for the upper portion 210 can enter through an inlet 226 and exit through an outlet 228.

One or more gases are provided to the processing volume 216 of the quartz chamber 208 by a gas injection assembly 230, and processing byproducts are removed from the processing volume 216 by a gas exhaust assembly 232, which is typically in communication with a vacuum source (not shown).

The process kit 214 further includes multiple cylindrical liners, an inner liner 234 and an outer liner 236 that shield the processing volume 216 from side walls 242 of the housing structure 202. The inner liner 234 includes one or more inlet holes 264 on a side facing the gas injection assembly 230 in the -*X* direction (referred to as an "injection side" hereinafter) and one or more outlet holes 270 an a side facing the gas exhaust assembly 232 in the +*X* direction (referred to as an "exhaust side" hereinafter). The outer liner 236 includes one or more inlet holes 260 on the injection side and one or more outlet holes 272 on the exhaust side. Between the inner liner 234 and the outer liner 236, a ring reflector 238 is disposed. The ring reflector 238 includes one or more inlet holes 262 on the injection side and one or more outlet holes 274 on the exhaust side. The ring reflector 238 is generally of a cylindrical tubular structure with a reflective surface facing the inner liner 234. The reflective surface of the ring reflector 238 reflects radiant heat from the inner liner 234 and confines the heat within the inner liner 234 that could otherwise escape the inner liner 234. The ring reflector 238 is formed of opaque quartz or silicon-carbide (SiC) coated graphite. In some embodiments, an inner surface of the ring reflector 238 facing the inner liner 234 is coated with a highly reflective material, such as gold, to prevent heat loss. In some other embodiments, the inner surface of the ring reflector 238 facing the inner liner 234 is coated with a reflective material, such as silica, for example, Heraeus Reflective Coating, HRC^{®}. The inner liner 234 acts as cylinder walls to the processing volume 216 that houses a cassette 246 having a plurality of shelves 248 (e.g., five shelves are shown in Figure 2) to retain multiple substrates W for a batch multi-wafer process. The shelves 248 are interleaved between the substrates W retained in the cassette 246 so that a gap exists between the shelves 248 and the substrates W to allow efficient mechanical transfer of the substrates W to and from the shelves 248. A substrate W may be transferred into and from the processing volume 216 by a transfer robot, such as the transfer robots 110, 118 shown in Figure 1, via a slip opening (not shown) formed in the outer liner 236 on a front side facing the -Y direction. In some embodiments, substrates W are transferred into and from the cassette 246 one by one. In some embodiments, the slit opening of the outer liner 236 is openable and closable by using a slit valve (not shown).

The process kit 214 further includes a top plate 250 and a bottom plate 252 that are attached to an inner surface of the inner liner 234 and enclose the cylindrical processing volume 216 within the process kit 214. The top plate 250 and the bottom plate 252 are disposed at a sufficient distance apart from the shelves 248 to allow gas flow over substrates W retained in the shelves 248.

The inner liner 234 is formed of clear quartz, silicon-carbide (SiC) coated graphite, graphite, or silicon carbide (SiC). The top plate 250 and the bottom plate 252 are formed of clear quartz, opaque quartz, silicon-carbide (SiC) coated graphite, graphite, silicon carbide (SiC), or silicon (Si), such that heat loss from the processing volume 216 through the top plate 250 and/or the bottom plate 252 is reduced. The shelves 248 of the cassette 246 disposed within the processing volume 216 are also formed of material, such as silicon-carbide (SiC) coated graphite, graphite, or silicon carbide (SiC). The outer liner 236 is formed of material having a high reflectivity, such as opaque quartz, and further reduce heat loss from the processing volume 216 within the process kit 214. In some embodiments, the outer liner 236 is formed in a hollow structure, in which vacuum between an inner surface of the outer liner 236 facing the inner liner 234 and an outer surface of the outer liner 236 facing the side walls 242 of the housing structure 202 reduces heat conduction through the outer liner 236.

The gases can be injected to the processing volume 216 from a first gas source 254, such as hydrogen (H₂), nitrogen (N₂), or any carrier gas, along with or without a second gas source 256 of the gas injection assembly 230 through the inlet holes 264 formed in the inner liner 234. The inlet holes 264 in the inner liner 234 are in fluid communication with the first gas source 254 and the second gas source 256 via an injection plenum 258 formed in the side wall 242, the inlet holes 260 formed in the outer liner 236, and the inlet holes 262 formed in the ring reflector 238. The injected gases form gas flow along a laminar flow path 266. The inlet holes 260, 262, 264 may be configured to provide gas flows with varied parameters, such as velocity, density, or composition.

The gases along the flow path 266 are configured to flow across the processing volume 216 into an exhaust plenum 268 formed in the side wall 242 to be exhausted by the gas exhaust assembly 232 from the processing volume 216. The gas exhaust assembly 232 is in fluid communication with the outlet holes 270 formed in the inner liner 234 via the outlet holes 272 formed in the outer liner 236, the outlet holes 274 formed in the ring reflector 238, and the exhaust plenum 268, culminating the gases in an exhaust flow path 278. The exhaust plenum 268 is coupled to an exhaust or vacuum pump (not shown). At least the injection plenum 258 may be supported by an inject cap 280. In some embodiments, the processing chamber 200 is adapted to supply one or more liquids for processes, such as deposition and etch processes. Furthermore, although only two gas sources 254, 256 are shown in Figure 2, the processing chamber 200 could be adapted to accommodate as many fluid connections as needed for the processes executed in the processing chamber 200.

The support system 204 includes components used to execute and monitor pre-determined processes in the processing chamber 200. A controller 206 is coupled to the support system 204 and is adapted to control the processing chamber 200 and support system 204.

The processing chamber 200 includes a lift-rotation mechanism 282 positioned in the lower portion 212 of the housing structure 202. The lift-rotation mechanism 282 includes a shaft 284 positioned within a shroud 286 to which lift pins (not shown) disposed through openings (not labeled) formed in the shelves 248 of the process kit 214 is coupled. The shaft 284 is movable vertically in the Z-direction to allow loading substrates W into and unloading substrates W from the shelves 248 through a slit opening (not shown) in the inner liner 234 and a slit opening not shown in the outer liner 236 by a transfer robot, such as the transfer robots 110, 118 shown in Figure 1. The shaft 284 is also rotatable in order to facilitate the rotation of substrates W disposed within the process kit 214 in the *X-Y* plane during processing. Rotation of the shaft 284 is facilitated by an actuator 288 coupled to the shaft 284. The shroud 286 is generally fixed in position, and therefore, does not rotate during processing.

The quartz chamber 208 includes peripheral flanges 290, 292 that are attached to and vacuum sealed to the side walls 242 of the housing structure 202 using O-rings 294. The peripheral flanges 290, 292 may all be formed from an opaque quartz to protect O-rings 294 from being directly exposed to the heat radiation. The peripheral flange 290 may be formed of an optically transparent material such as quartz.

In the example embodiments described herein, the process kit 214 includes an edge temperature correcting element disposed between the inner liner 234 and the ring reflector 238 that improves temperature uniformity over each substrate W retained in the shelves 248 in the processing volume 216 by compensating for or reducing heat loss from the processing volume 216 in the vicinity of edges of the substrates W.

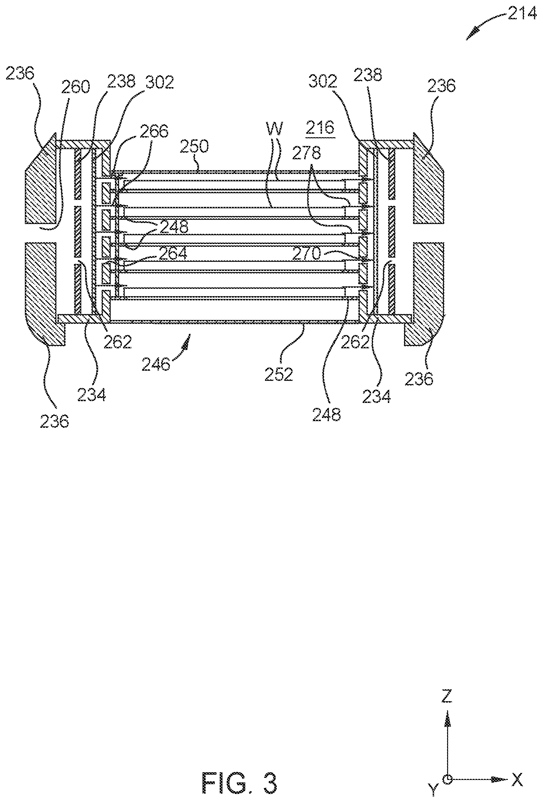

Figure 3 is a schematic cross-sectional view of the process kit 214 according to one embodiment. In the example embodiment shown in Figure 3, the edge temperature correcting element is two heaters 302 that surround the inner liner 234. One heater 302 is disposed on the injection side and the other heater 302 is disposed on the exhaust side. The heaters 302 may be adapted to heat the substrates W retained in the shelves 248 additionally to the upper lamp modules 218A, 218B and the lower lamp modules 220A, 220B and compensate for heat losses from the processing volume 216 in the vicinity of the inner liner 234.

The heaters 302 can be a graphite heater of a cylindrical shape. In some embodiments, the heaters 302 are formed of silicon-carbide (SiC) coated graphite. One or more terminals (not shown) are provided to support the heaters 302. The heaters 302 each include a plurality of slits extending in the Z-direction, allowing efficient generation of heat generation and flow of the gases through the inner liner 234. Spatial arrangement and sizes of the plurality of slits can be adjusted to provide desired temperature gradient in the Z-direction. In one example, the heaters 302 each have a length in the Z-direction of between about 1,000 mm and about 3,500 mm, a height of between about 25 mm and about 125 mm, a thickness of between about 4 mm and about 8 mm, and a width of between about 4mm and about 12 mm. The heaters 302 can heat the substrates W retained in the shelves 248 up to about 1200 °C. In some embodiments, temperatures of the substrates W in the vicinity of the inner liner 234 can be tuned at a desired temperature by adjustment of power delivered to the heaters 302.

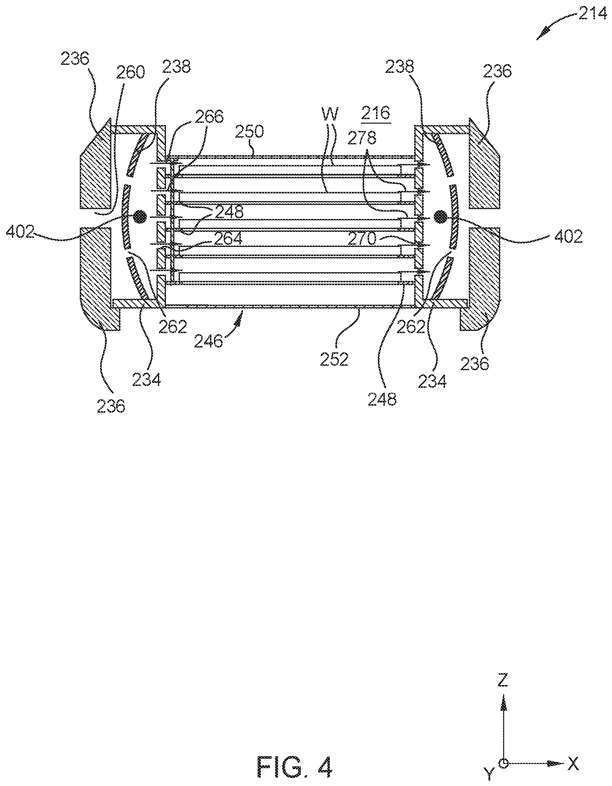

Figure 4 is a schematic cross-sectional view of the process kit 214 according to one embodiment. In the example embodiment shown in Figure 4, the edge temperature correcting element is a heater 402 that encircles the inner liner 234. The heater 402 may be adapted to heat the substrates W retained in the shelves 248 additionally to the upper lamp modules 218A, 218B and the lower lamp modules 220A, 220B and compensate for heat losses from the processing volume 216 in the vicinity of the inner liner 234.

The heater 402 can be a lamp, for example a lamp of a toroidal shape, disposed between the inner liner 234 and the ring reflector 238, and provide radiant energy to the substrates W retained in the shelves 248, leading to efficient heating with a short ramp-up and ramp-down time. Due to the toroidal shape of the lamp encircling the inner liner 234, the heater 402 allows flow of the gases between the inlet holes 260 of the outer liner 236 and the outlet holes 272 of the outer liner without obstruction. In some embodiments, the heater 402 is a toroidal bulb having a filament disposed therein.

In some embodiments, the ring reflector 238 is curved to create a sufficient space to accommodate the heater 402 of a toroidal shape between the inner liner 234 and the ring reflector 238.

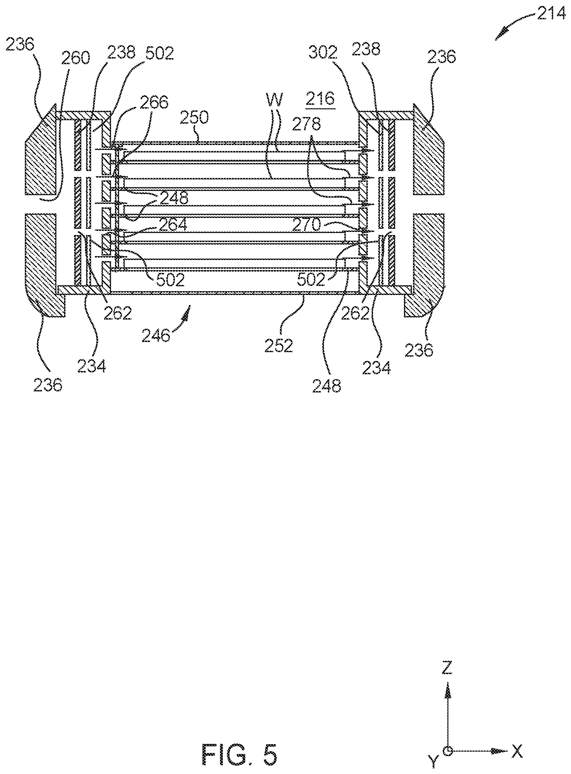

Figure 5 is a schematic cross-sectional view of the process kit 214 according to one embodiment. In the example embodiment shown in Figure 5, the edge temperature correcting element is one or more additional ring reflector 502 that surround the inner liner 234. The one or more additional ring reflector 502 may be formed of the same material as the ring reflector 238 or a different material, and are adapted to act as a radiation/conduction heat shield within the inner liner 234, thus reducing heat loss from the processing volume 216 in the vicinity of the inner liner 234. The additional ring reflector 506 also includes one or more inlet holes (not labeled) on the injection side and one or more outlet holes (not labeled), allowing flow of the gases through the inner liner 234.

In examples described herein, a multi-wafer batch processing system is shown where multiple substrates are pre-cleaned to remove contaminants, such as oxides, prior to thin film growth thereon by epitaxial processes by baking the substrates in a hydrogen atmosphere in an epitaxial (Epi) chamber while uniform temperature distribution is maintained over a substrate, in particular in the vicinity of edges of the substrate, disposed within a processing volume. Thus, the multi-wafer batch processing system may provide required qualities and throughputs in fabricated devices.

While the foregoing is directed to various examples of the present disclosure, other and further examples may be devised without departing from the basic scope thereof, and the scope thereof is determined by the claims that follow.

## Claims

1. A process kit (214) for use in a processing chamber (200), the process kit comprising:
an inner liner (234) having:
a plurality of first inlet holes (264) disposed on an injection side of the inner liner and configured to be in fluid communication with a gas injection assembly (230) of a processing chamber; and
a plurality of first outlet holes (270) disposed on an exhaust side of the inner liner (234) and configured to be in fluid communication with a gas exhaust assembly (232) of the processing chamber;
a top plate (250) and a bottom plate (252) attached to an inner surface of the inner liner (234), the top plate and the bottom plate forming an enclosure together with the inner liner;
a cassette (246) disposed within the enclosure, the cassette comprising a plurality of shelves (248) configured to retain a plurality of substrates thereon;
a first ring reflector (238) disposed outside of the inner liner (234); and
an edge temperature correcting element disposed between the inner liner and the first ring reflector, and
an outer liner (236) formed as a hollow structure and disposed outside the first ring reflector (238), wherein the outer liner comprises material selected from opaque quartz and silicon-carbide (SiC) coated graphite.

2. The process kit (214) of claim 1, wherein
the inner liner (234) comprises material selected from clear quartz and silicon-carbide (SiC) coated graphite, and
the top plate (250) and the bottom plate (252) comprise material selected from clear quartz, opaque quartz, silicon-carbide (SiC) coated graphite.

3. The process kit (214) of claim 1, wherein
the first ring reflector (238) comprises material selected from opaque quartz or silicon-carbide (SiC) coated graphite, and
the plurality of shelves (248) comprises silicon-carbide (SiC) coated graphite.

4. The process kit (214) of claim 1, wherein the edge temperature correcting element comprises two graphite heaters (302) surrounding the inner liner (234).

5. The process kit (214) of claim 1, wherein the edge temperature correcting element comprises a lamp between the inner liner and the first ring reflector.

6. The process kit (214) of claim 1, wherein the edge temperature correcting element comprises a toroidal lamp encircling the inner liner.

7. The process kit (214) of claim 1, wherein
the edge temperature correcting element comprises a second ring reflector (502) surrounding the inner liner (234), and
the second ring reflector (502) comprises material selected from opaque quartz or silicon-carbide (SiC) coated graphite.

8. A processing chamber (200), comprising:
a housing structure (202) having a first side wall and a second side wall opposite the first side wall in a first direction;
a gas injection assembly (230) coupled to the first side wall;
a gas exhaust assembly (232) coupled to the second side wall;
a quartz chamber (208) disposed within the housing structure;
the process kit (214) according to claim 1 or any one of the claims 5 to 7 disposed within the quartz chamber;
a plurality of upper lamp modules (218A, 218B) disposed on a first side of the quartz chamber and configured to provide radiative heat to the plurality of substrates;
a plurality of lower lamp modules (220A, 220B) disposed on a second side of the quartz chamber opposite the first side in a second direction perpendicular to the first direction and configured to provide radiative heat to the plurality of substrates; and
a lift-rotation mechanism (282) configured to move the cassette (246) in the second direction and rotate the cassette about the second direction;
the inner liner (234) having:
the plurality of first inlet holes (264) configured to be in fluid communication with the gas injection assembly (230); and
the plurality of first outlet holes (270) configured to be in fluid communication with the gas exhaust assembly (232).

9. The processing chamber (200) of claim 8, wherein
the inner liner comprises material selected from clear quartz and silicon-carbide (SiC) coated graphite,
the top plate and the bottom plate comprise material selected from clear quartz, opaque quartz, silicon-carbide (SiC) coated graphite,
the first ring reflector comprises material selected from opaque quartz or silicon-carbide (SiC) coated graphite, and
the plurality of shelves comprises silicon-carbide (SiC) coated graphite.

10. The processing chamber (200) of claim 8, wherein
the edge temperature correcting element comprises a second ring reflector surrounding the inner liner, and
the second ring reflector comprises material selected from opaque quartz or silicon-carbide (SiC) coated graphite.

11. A processing system (100) comprising:
a processing chamber (200) comprising:
a housing structure having a first side wall and a second side wall opposite the first side wall in a first direction;
a gas injection assembly coupled to the first side wall;
a gas exhaust assembly coupled to the second side wall;
a quartz chamber disposed within the housing structure;
the process kit (214) according to claim 1 or any one of the claims 4 to 6 disposed within the quartz chamber, the process kit comprising:
the inner liner having:
the plurality of first inlet holes configured to be in fluid communication with the gas injection assembly; and
the plurality of first outlet holes configured to be in fluid communication with the gas exhaust assembly; and
a plurality of upper lamp modules disposed on a first side of the quartz chamber and configured to provide radiative heat to the plurality of substrates;
a plurality of lower lamp modules disposed on a second side of the quartz chamber opposite the first side in a second direction perpendicular to the first direction and configured to provide radiative heat to the plurality of substrates;
a lift-rotation mechanism configured to move the cassette in the second direction and rotate the cassette about the second direction; and
a transfer robot configured to transfer the plurality of substrates into and from the process kit (214) disposed in the processing chamber.

12. The processing system (100) of claim 11, wherein
the inner liner comprises material selected from clear quartz and silicon-carbide (SiC) coated graphite,
the first ring reflector comprises material selected from opaque quartz or silicon-carbide (SiC) coated graphite, and
the plurality of shelves comprises silicon-carbide (SiC) coated graphite.

13. The processing system (100) of claim 12, wherein
the edge temperature correcting element comprises a second ring reflector surrounding the inner liner, and
the second ring reflector comprises material selected from opaque quartz or silicon-carbide (SiC) coated graphite.

## Patentansprüche

1. Prozesskit (214) zur Verwendung in einer Prozesskammer (200), wobei das Prozesskit umfasst:
eine innere Auskleidung (234) mit:
einer Vielzahl von ersten Einlasslöchern (264), die auf einer Injektionsseite der inneren Auskleidung angeordnet sind und konfiguriert sind, um in Fluidverbindung mit einer Gasinjektionsanordnung (230) einer Prozesskammer zu stehen; und
einer Vielzahl von ersten Auslasslöchern (270), die auf einer Abgasseite der inneren Auskleidung (234) angeordnet sind und konfiguriert sind, um in Fluidverbindung mit einer Gasabzugsanordnung (232) der Prozesskammer zu stehen;
einer oberen Platte (250) und einer unteren Platte (252), die an einer Innenfläche der inneren Auskleidung (234) befestigt sind, wobei die obere Platte und die untere Platte zusammen mit der inneren Auskleidung eine Umschließung bilden;
einer Kassette (246), die innerhalb der Umschließung angeordnet ist, wobei die Kassette eine Vielzahl von Ablagen (248) umfasst, die konfiguriert sind, um eine Vielzahl von Substraten darauf zu halten;
einem ersten Ringreflektor (238), der außerhalb der inneren Auskleidung (234) angeordnet ist; und
einem Randtemperaturkorrekturelement, das zwischen der inneren Auskleidung und dem ersten Ringreflektor angeordnet ist, und
einer äußeren Auskleidung (236), die als eine hohle Struktur gebildet ist und außerhalb des ersten Ringreflektors (238) angeordnet ist, wobei die äußere Auskleidung Material umfasst, das ausgewählt ist aus opakem Quarz und mit Siliziumkarbid (SiC) beschichtetem Graphit.

2. Prozesskit (214) nach Anspruch 1, wobei
die innere Auskleidung (234) Material umfasst, das ausgewählt ist aus klarem Quarz und mit Siliziumkarbid (SiC) beschichtetem Graphit, und
die obere Platte (250) und die untere Platte (252) Material umfassen, das ausgewählt ist aus klarem Quarz, opakem Quarz, mit Siliziumkarbid (SiC) beschichtetem Graphit.

3. Prozesskit (214) nach Anspruch 1, wobei
der erste Ringreflektor (238) Material umfasst, das ausgewählt ist aus opakem Quarz oder mit Siliziumkarbid (SiC) beschichtetem Graphit, und
die Vielzahl von Ablagen (248) mit Siliziumkarbid (SiC) beschichteten Graphit umfasst.

4. Prozesskit (214) nach Anspruch 1, wobei das Randtemperaturkorrekturelement zwei Graphitheizer (302) umfasst, die die innere Auskleidung (234) umgeben.

5. Prozesskit (214) nach Anspruch 1, wobei das Randtemperaturkorrekturelement eine Lampe zwischen der inneren Auskleidung und dem ersten Ringreflektor umfasst.

6. Prozesskit (214) nach Anspruch 1, wobei das Randtemperaturkorrekturelement eine toroidale Lampe umfasst, die die innere Auskleidung einkreist.

7. Prozesskit (214) nach Anspruch 1, wobei
das Randtemperaturkorrekturelement einen zweiten Ringreflektor (502) umfasst, der die innere Auskleidung (234) umgibt, und der zweite Ringreflektor (502) Material umfasst, das ausgewählt ist aus opakem Quarz oder mit Siliziumkarbid (SiC) beschichtetem Graphit.

8. Prozesskammer (200), umfassend:
eine Gehäusestruktur (202) mit einer ersten Seitenwand und einer zweiten Seitenwand gegenüber der ersten Seitenwand in einer ersten Richtung;
eine Gasinjektionsanordnung (230), die mit der ersten Seitenwand gekoppelt ist;
eine Gasabzugsanordnung (232), die mit der zweiten Seitenwand gekoppelt ist;
eine Quarzkammer (208), die innerhalb der Gehäusestruktur angeordnet ist;
das Prozesskit (214) nach Anspruch 1 oder einem der Ansprüche 5 bis 7, das innerhalb der Quarzkammer angeordnet ist;
eine Vielzahl von oberen Lampenmodulen (218A, 218B), die auf einer ersten Seite der Quarzkammer angeordnet sind und konfiguriert sind, um der Vielzahl von Substraten Strahlungswärme bereitzustellen;
eine Vielzahl von unteren Lampenmodulen (220A, 220B), die auf einer zweiten Seite der Quarzkammer gegenüber der ersten Seite in einer zweiten Richtung senkrecht zur ersten Richtung angeordnet sind und konfiguriert sind, um der Vielzahl von Substraten Strahlungswärme bereitzustellen; und
einen Hebe-Dreh-Mechanismus (282), der konfiguriert ist, um die Kassette (246) in der zweiten Richtung zu bewegen und die Kassette um die zweite Richtung zu drehen;
die innere Auskleidung (234) mit:
der Vielzahl von ersten Einlasslöchern (264), die konfiguriert sind, um in Fluidverbindung mit der Gasinjektionsanordnung (230) zu stehen; und
der Vielzahl von ersten Auslasslöchern (270), die konfiguriert sind, um in Fluidverbindung mit der Gasabzugsanordnung (232) zu stehen.

9. Prozesskammer (200) nach Anspruch 8, wobei
die innere Auskleidung Material umfasst, das ausgewählt ist aus klarem Quarz und mit Siliziumkarbid (SiC) beschichtetem Graphit,
die obere Platte und die untere Platte Material umfassen, das ausgewählt ist aus klarem Quarz, opakem Quarz, mit Siliziumkarbid (SiC) beschichtetem Graphit,
der erste Ringreflektor Material umfasst, das ausgewählt ist aus opakem Quarz oder mit Siliziumkarbid (SiC) beschichtetem Graphit, und
die Vielzahl von Ablagen mit Siliziumkarbid (SiC) beschichteten Graphit umfasst.

10. Prozesskammer (200) nach Anspruch 8, wobei
das Randtemperaturkorrekturelement einen zweiten Ringreflektor umfasst, der die innere Auskleidung umgibt, und der
zweite Ringreflektor Material umfasst, das ausgewählt ist aus opakem Quarz oder mit Siliziumkarbid (SiC) beschichtetem Graphit.

11. Prozesssystem (100) umfassend:
eine Prozesskammer (200) umfassend:
eine Gehäusestruktur mit einer ersten Seitenwand und einer zweiten Seitenwand gegenüber der ersten Seitenwand in einer ersten Richtung;
eine Gasinjektionsanordnung, die mit der ersten Seitenwand gekoppelt ist;
eine Gasabzugsanordnung, die mit der zweiten Seitenwand gekoppelt ist;
eine Quarzkammer, die innerhalb der Gehäusestruktur angeordnet ist;
das Prozesskit (214) nach Anspruch 1 oder einem der Ansprüche 4 bis 6, das innerhalb der Quarzkammer angeordnet ist, wobei das Prozesskit umfasst:
die innere Auskleidung mit:
der Vielzahl von ersten Einlasslöchern, die konfiguriert sind, um in Fluidverbindung mit der Gasinjektionsanordnung zu stehen; und
der Vielzahl von ersten Auslasslöchern, die konfiguriert sind, um in Fluidverbindung mit der Gasabzugsanordnung zu stehen; und
eine Vielzahl von oberen Lampenmodulen, die auf einer ersten Seite der Quarzkammer angeordnet sind und konfiguriert sind, um der Vielzahl von Substraten Strahlungswärme bereitzustellen;
eine Vielzahl von unteren Lampenmodulen, die auf einer zweiten Seite der Quarzkammer gegenüber der ersten Seite in einer zweiten Richtung senkrecht zur ersten Richtung angeordnet sind und konfiguriert sind, um der Vielzahl von Substraten Strahlungswärme bereitzustellen;
einen Hebe-Dreh-Mechanismus, der konfiguriert ist, um die Kassette in der zweiten Richtung zu bewegen und die Kassette um die zweite Richtung zu drehen; und
einen Transferroboter, der konfiguriert ist, um die Vielzahl von Substraten in das und aus dem Prozesskit (214), das in der Prozesskammer angeordnet ist, zu transferieren.

12. Prozesssystem (100) nach Anspruch 11, wobei
die innere Auskleidung Material umfasst, das ausgewählt ist aus klarem Quarz und mit Siliziumkarbid (SiC) beschichtetem Graphit,
der erste Ringreflektor Material umfasst, das ausgewählt ist aus opakem Quarz oder mit Siliziumkarbid (SiC) beschichtetem Graphit, und
die Vielzahl von Ablagen mit Siliziumkarbid (SiC) beschichteten Graphit umfasst.

13. Prozesssystem (100) nach Anspruch 12, wobei
das Randtemperaturkorrekturelement einen zweiten Ringreflektor umfasst, der die innere Auskleidung umgibt, und
der zweite Ringreflektor Material umfasst, das ausgewählt ist aus opakem Quarz oder mit Siliziumkarbid (SiC) beschichtetem Graphit.

## Revendications

1. Kit de procédé (214) destiné à être utilisé dans une chambre de traitement (200), le kit de procédé comprenant:
une chemise intérieure (234) ayant:
une pluralité de premiers orifices d'entrée (264) disposés sur un côté injection de la chemise intérieure et configurés pour être en communication fluidique avec un ensemble d'injection de gaz (230) d'une chambre de traitement; et
une pluralité de premiers orifices de sortie (270) disposés sur un côté évacuation de la chemise intérieure (234) et configurés pour être en communication fluidique avec un ensemble d'évacuation de gaz (232) de la chambre de traitement;
une plaque supérieure (250) et une plaque inférieure (252) fixées à une surface intérieure de la chemise intérieure (234), la plaque supérieure et la plaque inférieure formant une enceinte conjointement avec la chemise intérieure;
une cassette (246) disposée à l'intérieur de l'enceinte, la cassette comprenant une pluralité de plateaux (248) configurés pour retenir une pluralité de substrats sur eux;
un premier réflecteur annulaire (238) disposé à l'extérieur de la chemise intérieure (234); et
un élément de correction de température de bord disposé entre la chemise intérieure et le premier réflecteur annulaire, et
une chemise extérieure (236) formée comme une structure creuse et disposée à l'extérieur du premier réflecteur annulaire (238), dans lequel la chemise extérieure comprend un matériau choisi parmi le quartz opaque et le graphite revêtu de carbure de silicium (SiC).

2. Kit de procédé (214) selon la revendication 1, dans lequel
la chemise intérieure (234) comprend un matériau choisi parmi le quartz transparent et le graphite revêtu de carbure de silicium (SiC), et
la plaque supérieure (250) et la plaque inférieure (252) comprennent un matériau choisi parmi le quartz transparent, le quartz opaque, le graphite revêtu de carbure de silicium (SiC).

3. Kit de procédé (214) selon la revendication 1, dans lequel
le premier réflecteur annulaire (238) comprend un matériau choisi parmi le quartz opaque ou le graphite revêtu de carbure de silicium (SiC), et
la pluralité de plateaux (248) comprend du graphite revêtu de carbure de silicium (SiC).

4. Kit de procédé (214) selon la revendication 1, dans lequel l'élément de correction de température de bord comprend deux éléments chauffants en graphite (302) entourant la chemise intérieure (234).

5. Kit de procédé (214) selon la revendication 1, dans lequel l'élément de correction de température de bord comprend une lampe entre la chemise intérieure et le premier réflecteur annulaire.

6. Kit de procédé (214) selon la revendication 1, dans lequel l'élément de correction de température de bord comprend une lampe toroïdale entourant la chemise intérieure.

7. Kit de procédé (214) selon la revendication 1, dans lequel
l'élément de correction de température de bord comprend un second réflecteur annulaire (502) entourant la chemise intérieure (234), et
le second réflecteur annulaire (502) comprend un matériau choisi parmi le quartz opaque ou le graphite revêtu de carbure de silicium (SiC).

8. Chambre de traitement (200), comprenant:
une structure de boîtier (202) ayant une première paroi latérale et une seconde paroi latérale opposée à la première paroi latérale dans une première direction;
un ensemble d'injection de gaz (230) couplé à la première paroi latérale;
un ensemble d'évacuation de gaz (232) couplé à la seconde paroi latérale;
une chambre en quartz (208) disposée à l'intérieur de la structure de boîtier;
le kit de procédé (214) selon la revendication 1 ou l'une quelconque des revendications 5 à 7 disposé à l'intérieur de la chambre en quartz;
une pluralité de modules de lampes supérieurs (218A, 218B) disposés sur un premier côté de la chambre en quartz et configurés pour fournir de la chaleur radiative à la pluralité de substrats;
une pluralité de modules de lampes inférieurs (220A, 220B) disposés sur un second côté de la chambre en quartz opposé au premier côté dans une seconde direction perpendiculaire à la première direction et configurés pour fournir de la chaleur radiative à la pluralité de substrats; et
un mécanisme de levage et de rotation (282) configuré pour déplacer la cassette (246) dans la seconde direction et faire tourner la cassette autour de la seconde direction;
la chemise intérieure (234) ayant:
la pluralité de premiers orifices d'entrée (264) configurés pour être en communication fluidique avec l'ensemble d'injection de gaz (230); et
la pluralité de premiers orifices de sortie (270) configurés pour être en communication fluidique avec l'ensemble d'évacuation de gaz (232).

9. Chambre de traitement (200) selon la revendication 8, dans laquelle
la chemise intérieure comprend un matériau choisi parmi le quartz transparent et le graphite revêtu de carbure de silicium (SiC),
la plaque supérieure et la plaque inférieure comprennent un matériau choisi parmi le quartz transparent, le quartz opaque, le graphite revêtu de carbure de silicium (SiC),
le premier réflecteur annulaire comprend un matériau choisi parmi le quartz opaque ou le graphite revêtu de carbure de silicium (SiC), et
la pluralité de plateaux comprend du graphite revêtu de carbure de silicium (SiC).

10. Chambre de traitement (200) selon la revendication 8, dans laquelle
l'élément de correction de température de bord comprend un second réflecteur annulaire entourant la chemise intérieure, et
le second réflecteur annulaire comprend un matériau choisi parmi le quartz opaque ou le graphite revêtu de carbure de silicium (SiC).

11. Système de traitement (100) comprenant:
une chambre de traitement (200) comprenant:
une structure de boîtier ayant une première paroi latérale et une seconde paroi latérale opposée à la première paroi latérale dans une première direction;
un ensemble d'injection de gaz couplé à la première paroi latérale;
un ensemble d'évacuation de gaz couplé à la seconde paroi latérale;
une chambre en quartz disposée à l'intérieur de la structure de boîtier;
le kit de procédé (214) selon la revendication 1 ou l'une quelconque des revendications 4 à 6 disposé à l'intérieur de la chambre en quartz, le kit de procédé comprenant:
la chemise intérieure ayant:
la pluralité de premiers orifices d'entrée configurés pour être en communication fluidique avec l'ensemble d'injection de gaz; et
la pluralité de premiers orifices de sortie configurés pour être en communication fluidique avec l'ensemble d'évacuation de gaz; et
une pluralité de modules de lampes supérieurs disposés sur un premier côté de la chambre en quartz et configurés pour fournir de la chaleur radiative à la pluralité de substrats;
une pluralité de modules de lampes inférieurs disposés sur un second côté de la chambre en quartz opposé au premier côté dans une seconde direction perpendiculaire à la première direction et configurés pour fournir de la chaleur radiative à la pluralité de substrats;
un mécanisme de levage et de rotation configuré pour déplacer la cassette dans la seconde direction et faire tourner la cassette autour de la seconde direction; et
un robot de transfert configuré pour transférer la pluralité de substrats vers et depuis le kit de procédé (214) disposé dans la chambre de traitement.

12. Système de traitement (100) selon la revendication 11, dans lequel
la chemise intérieure comprend un matériau choisi parmi le quartz transparent et le graphite revêtu de carbure de silicium (SiC),
le premier réflecteur annulaire comprend un matériau choisi parmi le quartz opaque ou le graphite revêtu de carbure de silicium (SiC), et
la pluralité de plateaux comprend du graphite revêtu de carbure de silicium (SiC).

13. Système de traitement (100) selon la revendication 12, dans lequel
l'élément de correction de température de bord comprend un second réflecteur annulaire entourant la chemise intérieure, et
le second réflecteur annulaire comprend un matériau choisi parmi le quartz opaque ou le graphite revêtu de carbure de silicium (SiC).
